# EUROPEAN PATENT APPLICATION

(11) **EP 4 836 210 A1**
(43) Date of publication of application: **04.11.2026**
(21) Application number: 24912032.0
(22) Date of filing: 06.11.2024
(51) Int. Cl.: H01S 5/20

(54) **SEMICONDUCTOR OPTICAL ELEMENT**

(30) Priority: 26.12.2023 JP 2023219113
(71) Applicant: Fujikura Ltd., Tokyo 135-8512 (JP)
(72) Inventor: MOROHASHI, Rintaro, Sakura-shi, Chiba 285-8550 (JP)
(74) Representative: Plasseraud IP
(86) International application number: PCT/JP2024/039422
(87) International publication number: WO 2025/142139

(57) **Abstract**

A semiconductor optical element includes a substrate, and a laminate in which a semiconductor layer of a first conductivity type, an active layer, and a semiconductor layer of a second conductivity type are laminated in order from a substrate side, in which at least one of the semiconductor layer of the first conductivity type and the semiconductor layer of the second conductivity type has a first waveguide layer and a second waveguide layer, and the second waveguide layer has a higher doping concentration than the first waveguide layer, and is disposed between the first waveguide layer and the active layer.

## Description

### TECHNICAL FIELD

The present invention relates to a semiconductor optical element.

Priority is claimed on Japanese Patent Application No. 2023-219113, filed December 26, 2023, the content of which is incorporated herein by reference.

### BACKGROUND ART

One example of a semiconductor optical element is an edge-emitting type semiconductor laser. A general edge-emitting type semiconductor laser is an element in which a first conductivity type (for example, n-type) cladding layer, a first conductivity type waveguide layer, an active layer, a second conductivity type (for example, p-type) waveguide layer, and a second conductivity type cladding layer are sequentially laminated on a substrate in a vertical direction. In such an edge-emitting type semiconductor laser, most of the light generated in the active layer by current injection is confined in the active layer and the waveguide layer and guided.

In recent years, as a structure for suppressing laser beam divergence (or beam divergence) in a vertical direction while having high output characteristics, a large optical cavity (LOC) structure having a relatively large waveguide layer thickness is used. Although there is no clear definition for the LOC structure, in a semiconductor laser having an oscillation wavelength in a 900 nm band, a structure in which the total thickness of the first conductivity type waveguide layer and the second conductivity type waveguide layer is about 1.5 to 2.5 µm is often used. For example, Patent Document 1 discloses an LOC structure in which the total waveguide layer thickness is 2.15 µm.

### Citation List

### Patent Document

Patent Document 1: United States Patent No. 8976831

### SUMMARY OF INVENTION

### Technical Problem

In the LOC structure having a large waveguide layer thickness, most of the generated laser light is guided by the active layer and the waveguide layer. In a case where a semiconductor layer through which laser light is guided is intentionally doped, a resistance value of an element can be reduced, but absorption of the laser light by a dopant, which is referred to as free carrier absorption, occurs, and laser emission efficiency is significantly reduced. In an extreme case, laser oscillation itself may be impossible due to free carrier absorption.

Therefore, from the balance between the resistance value of the element and the laser emission efficiency, the doping concentration of the waveguide layer in the LOC structure is generally suppressed to be low. For example, in Patent Document 1 described above, an active layer and layers contiguous to the active layer on both sides of the active layer are undoped layers that are not intentionally doped, and the n-type waveguide layer has the doping concentration of approximately 1 × 10¹⁶ cm⁻³.

In addition, in the LOC structure, since the thickness of the waveguide layer, in which the doping concentration is generally often suppressed to be low, is large, the resistance value of the element is likely to increase, and the operating voltage is likely to increase. In addition, in the above-described structure, since the doping concentrations of the n-type waveguide layer and the p-type waveguide layer are both low, the spread of the depletion layer is large, and the operating voltage may further increase.

The present invention has been made in view of the above circumstances, and an object of the present invention is to provide a semiconductor optical element capable of reducing an operating voltage without causing a significant decrease in light emission efficiency.

### Solution to Problem

In order to solve the above problems, a semiconductor optical element (1, 2) according to a first aspect of the present invention includes a substrate (10), and a laminate (20) in which a first conductivity type semiconductor layer (30), an active layer (40), and a second conductivity type semiconductor layer (50) are laminated in order from a substrate side, in which at least one of the first conductivity type semiconductor layer and the second conductivity type semiconductor layer has a first waveguide layer (32) and a second waveguide layer (33), and the second waveguide layer has a higher doping concentration than the first waveguide layer, and is disposed between the first waveguide layer and the active layer.

In the semiconductor optical element according to the first aspect of the present invention, the first waveguide layer and the second waveguide layer are provided in at least one of the first conductivity type semiconductor layer and the second conductivity type semiconductor layer laminated to sandwich the active layer, and the second waveguide layer has a higher doping concentration than the first waveguide layer and is disposed between the first waveguide layer and the active layer, thereby reducing the operating voltage without causing a significant decrease in light emission efficiency.

A semiconductor optical element according to a second aspect of the present invention is the semiconductor optical element according to the first aspect of the present invention, in which the doping concentration of the second waveguide layer is two times or more the doping concentration of the first waveguide layer.

A semiconductor optical element according to a third aspect of the present invention is the semiconductor optical element according to the second aspect of the present invention, in which the doping concentration of the second waveguide layer is 1 × 10¹⁷ cm⁻³ or more and 1 × 10¹⁸ cm⁻³ or less.

A semiconductor optical element according to a fourth aspect of the present invention is the semiconductor optical element according to the second aspect of the present invention, in which at least one of the first conductivity type semiconductor layer and the second conductivity type semiconductor layer has, in addition to the first waveguide layer and the second waveguide layer, an undoped layer (34) that is not doped and is disposed between the second waveguide layer and the active layer, and the doping concentration of the second waveguide layer is 5 × 10¹⁷ cm⁻³ or more and 1 × 10¹⁸ cm⁻³ or less.

A semiconductor optical element according to a fifth aspect of the present invention is the semiconductor optical element according to any one of the first to fourth aspects of the present invention, in which the thickness of the second waveguide layer is 25 nm or more and 50 nm or less.

A semiconductor optical element according to a sixth aspect of the present invention is the semiconductor optical element according to any one of the first to fifth aspects of the present invention, in which the doping concentration of the first waveguide layer is 3 × 10¹⁶ cm⁻³ or more and 5 × 10¹⁶ cm⁻³ or less.

### Advantageous Effects of Invention

According to the aspects of the present invention, there is an effect that the operating voltage can be reduced without causing a significant decrease in light emission efficiency.

### BRIEF DESCRIPTION OF DRAWINGS

[FIG. 1] A cross-sectional view showing the schematic configuration of a semiconductor optical element according to a first embodiment of the present invention.
[FIG. 2] A cross-sectional view showing the schematic configuration of a semiconductor optical element according to a second embodiment of the present invention.
[FIG. 3] A diagram showing an example of the specific configuration of a semiconductor optical element according to the embodiment of the present invention.
[FIG. 4] A diagram showing a change in current-voltage characteristics when the configuration of an n-side layer contiguous to an active layer is changed in the semiconductor optical element having the configuration shown in FIG. 3.
[FIG. 5] A diagram summarizing the configurations of n-side layers contiguous to an active layer in Examples 1 to 4 and Comparative Example shown in FIG. 4.
[FIG. 6] A diagram showing a change in output and PCE when the doping concentration of a second waveguide layer contiguous to an active layer is changed in the semiconductor optical element having the configuration shown in FIG. 3.
[FIG. 7] A diagram showing a change in a relationship between current per unit length and voltage when the thickness of the second waveguide layer contiguous to the active layer is changed in the semiconductor optical element having the configuration shown in FIG. 3.
[FIG. 8] A diagram showing a change in output, PCE, and resistance value when the doping concentration of a first waveguide layer is changed in the semiconductor optical element having the configuration shown in FIG. 3.

### DESCRIPTION OF EMBODIMENTS

Hereinafter, a semiconductor optical element according to an embodiment of the present invention will be described in detail with reference to the drawings.

### [First Embodiment]

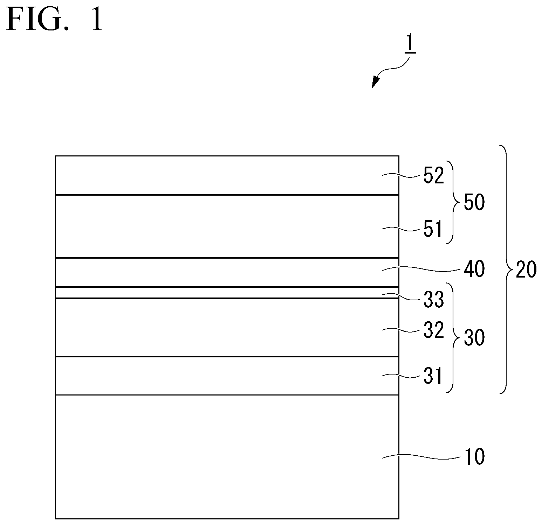

FIG. 1 is a cross-sectional view showing the schematic configuration of a semiconductor optical element according to a first embodiment of the present invention. As shown in FIG. 1, a semiconductor optical element 1 of the present embodiment includes a substrate 10 and a laminate 20 provided on the substrate 10.

The substrate 10 is a semiconductor substrate of a first conductivity type. In the laminate 20, a semiconductor layer 30 (first conductivity type semiconductor layer) which is a semiconductor layer of a first conductivity type, an active layer 40, and a semiconductor layer 50 (second conductivity type semiconductor layer) which is a semiconductor layer of a second conductivity type are laminated in order from the substrate 10 side. The semiconductor optical element 1 is, for example, a semiconductor laser element, a light-emitting diode, or the like. Electrodes (not shown) may be provided on each of the substrate 10 and the laminate 20 of the semiconductor optical element 1. In the present embodiment, to facilitate understanding, a case where the first conductivity type is an n-type and the second conductivity type is a p-type will be described as an example.

In the semiconductor layer 30, a cladding layer 31, a first waveguide layer 32, and a second waveguide layer 33 are laminated in order from the substrate 10 side. The active layer 40 generates light having a predetermined wavelength when a current is injected. In the semiconductor layer 50, a waveguide layer 51 and a cladding layer 52 are laminated in order from the active layer 40 side. The semiconductor optical element 1 of the present embodiment has a LOC structure in order to suppress laser beam divergence (or beam divergence) in a vertical direction while having high output characteristics. That is, the semiconductor optical element 1 of the present embodiment has a structure in which the thicknesses of the waveguide layers (the first waveguide layer 32, the second waveguide layer 33, and the waveguide layer 51) are relatively large.

In the present embodiment, the second waveguide layer 33 (a layer disposed between the first waveguide layer 32 and the active layer 40) in the semiconductor layer 30 has a higher doping concentration than the active layer 40 and the first waveguide layer 32. That is, in the present embodiment, a configuration in which a high-concentration doping layer is disposed near an interface between the semiconductor layer 30 and the active layer 40 is adopted. As a result, the spread of the depletion layer can be made smaller than in the related art, and the operating voltage of the semiconductor optical element 1 can be lowered.

The semiconductor layer 30, the active layer 40, and the semiconductor layer 50 can be formed, for example, by a metal organic chemical vapor deposition (MOCVD) method. In this case, as raw materials, necessary raw materials selected from trimethylgallium (TMG), trimethylaluminum (TMA), trimethylindium (TMI), arsine gas (AsH3), halomethanes such as carbon tetrabromide (CBr4) or carbon tetrachloride (CCl4), diethylzinc (DEZ), monosilane (SiH4), and the like may be appropriately used depending on the materials constituting each layer.

Hereinafter, the substrate 10 and the laminate 20 will be described in detail.

### <Substrate 10>

The substrate 10 contains a compound semiconductor and a dopant. Examples of the compound semiconductor include Group III-V compound semiconductors and the like such as GaAs, InP, and the like. Examples of the dopant include elements such as Si, Ge, Sn, S, Se, Te, and the like. These can be used alone or a combination of two or more thereof can be used. The thickness of the substrate 10 is not particularly limited, but is, for example, about 250 to 450 µm.

### <Laminate 20>

For example, as described above, the laminate 20 includes the semiconductor layer 30, the active layer 40, and the semiconductor layer 50. The laminate 20 contains a compound semiconductor. Examples of the compound semiconductor include GaAs, AlGaAs, InGaAs, InGaAlAs, InP, GaInP, AlInP, AlGaInP, InGaAsP, and the like.

### <<Semiconductor Layer 30>>

For example, as described above, the semiconductor layer 30 includes the cladding layer 31, the first waveguide layer 32, and the second waveguide layer 33. The cladding layer 31 is a layer for confining light generated in the active layer 40. The first waveguide layer 32 and the second waveguide layer 33 are layers in which light generated in the active layer 40 is propagated, together with the active layer 40.

The semiconductor layer 30 contains a compound semiconductor and a dopant. The compound semiconductor may be the same as or different from the compound semiconductor contained in the substrate 10. For example, in a case where the semiconductor layer 30 contains AlGaAs as the compound semiconductor, a composition of Al is denoted by x, and a composition ratio of Al and Ga is denoted by x:(1 - x). In this case, it is desirable that the first waveguide layer 32 and the second waveguide layer 33 of the semiconductor layer 30 have a composition x of Al of, for example, 0.1 ≤ x ≤ 0.2.

As the dopant, the same dopant as the dopant in the substrate 10 can be used. The second waveguide layer 33 has a higher doping concentration than the first waveguide layer 32. Specifically, the doping concentration of the second waveguide layer 33 is two times or more the doping concentration of the first waveguide layer 32. For example, the doping concentration of the first waveguide layer 32 is desirably a concentration in a range of 1 × 10¹⁶ to 1 × 10¹⁷ cm⁻³, and more desirably a concentration in a range of 3 × 10¹⁶ to 5 × 10¹⁶ cm⁻³. The doping concentration of the second waveguide layer 33 is desirably a concentration in a range of 1 × 10¹⁷ to 1 × 10¹⁸ cm⁻³, and more desirably a concentration in a range of 1 × 10¹⁷ to 5 × 10¹⁷ cm⁻³.

The thicknesses of the cladding layer 31 and the first waveguide layer 32 are not particularly limited, but are, for example, preferably about 1 µm. The thickness of the second waveguide layer 33 is desirably about 25 to 50 nm. The doping concentration and the thickness of the first waveguide layer 32 are designed in consideration of the balance between the resistance value of the semiconductor optical element 1 and a decrease in light emission efficiency due to free carrier absorption. The doping concentration and the thickness of the second waveguide layer 33 are designed to sufficiently suppress the spread of the depletion layer and to suppress the influence of an increase in the resistance value of the semiconductor optical element 1.

### <<Active Layer 40>>

The active layer 40 is a layer that has a band gap smaller than the band gaps of the semiconductor layer 30 and the semiconductor layer 50 and that generates light by current injection. The active layer 40 includes a compound semiconductor. The compound semiconductor is appropriately selected according to the wavelength of the light emitted from the semiconductor optical element 1. Examples of the compound semiconductor include InGaAs, GaAs, InGaAlAs, AlGaInP, InGaAsP, and the like.

The active layer 40 may be configured as, for example, a laminate including a quantum well layer between two barrier layers. The two barrier layers on both sides of the quantum well layer are layers including a compound semiconductor having a band gap larger than the band gap of the quantum well layer. The barrier layer may further include a dopant. The barrier layer can be configured as a layer having a constant doping concentration, a graded layer having the doping concentration that changes as the distance from the quantum well layer increases, or a laminate thereof. Alternatively, the barrier layer can be configured as a layer having a constant composition of elements in the compound semiconductor, a graded layer having a composition of elements in the compound semiconductor that changes along a direction away from the quantum well layer, or a laminate thereof.

The thickness of the active layer 40 is not particularly limited, but is, for example, about 30 to 70 nm. In addition, the active layer 40 may have a multiple quantum well structure in which a plurality of quantum well layers and barrier layers are alternately laminated.

### <<Semiconductor Layer 50>>

The semiconductor layer 50 includes, for example, a waveguide layer 51 and a cladding layer 52 as described above. The waveguide layer 51 is a layer in which light generated in the active layer 40 is propagated together with the active layer 40. The cladding layer 52 is a layer for confining the light generated in the active layer 40. That is, the light generated in the active layer 40 is propagated in the waveguide layer 51, the first waveguide layer 32 and the second waveguide layer 33 of the semiconductor layer 30, and the active layer 40 while being confined by the cladding layer 52 and the cladding layer 31 of the semiconductor layer 30.

The semiconductor layer 50 includes a compound semiconductor and a dopant. The compound semiconductor may be the same as or different from the compound semiconductor included in the substrate 10 or the semiconductor layer 30. For example, in a case where the semiconductor layer 50 includes AlGaAs as the compound semiconductor, the composition of Al is denoted by x, and the composition ratio of Al and Ga is denoted by x:(1 - x). It is desirable that the waveguide layer 51 of the semiconductor layer 50 satisfies, for example, 0.1 ≤ x ≤ 0.2. Examples of the dopant include elements such as C and the like. The doping concentration of the waveguide layer 51 may be the same as or different from the doping concentration of the first waveguide layer 32 in the semiconductor layer 30. For example, the doping concentration of the waveguide layer 51 is desirably a concentration in a range of 1 × 10¹⁶ to 1 × 10¹⁷ cm⁻³, and more desirably a concentration in a range of 3 × 10¹⁶ to 5 × 10¹⁶ cm⁻³.

The thickness of the waveguide layer 51 may be the same as or different from the thickness of the first waveguide layer 32 in the semiconductor layer 30. The thickness of the cladding layer 52 may be the same as or different from the thickness of the cladding layer 31 in the semiconductor layer 30. The thicknesses of the waveguide layer 51 and the cladding layer 52 are not particularly limited, but are preferably, for example, about 1 µm. Since the semiconductor optical element 1 of the present embodiment has the LOC structure as described above, a total thickness of the waveguide layer 51 and the first waveguide layer 32 and the second waveguide layer 33 of the semiconductor layer 30 is about 1.5 to 2.5 µm.

As described above, in the present embodiment, the second waveguide layer 33 (a layer disposed between the first waveguide layer 32 and the active layer 40) in the semiconductor layer 30 has a higher doping concentration than the active layer 40 and the first waveguide layer 32. As a result, the spread of the depletion layer can be made smaller than in the related art, and the operating voltage of the semiconductor optical element 1 can be lowered. In addition, since the thickness of the second waveguide layer 33 is sufficiently smaller than the thickness of the entire waveguide layer including the first waveguide layer 32, the active layer 40, and the waveguide layer 51, a decrease in light emission efficiency due to free carrier absorption does not occur (or is suppressed to a slight decrease).

### [Second Embodiment]

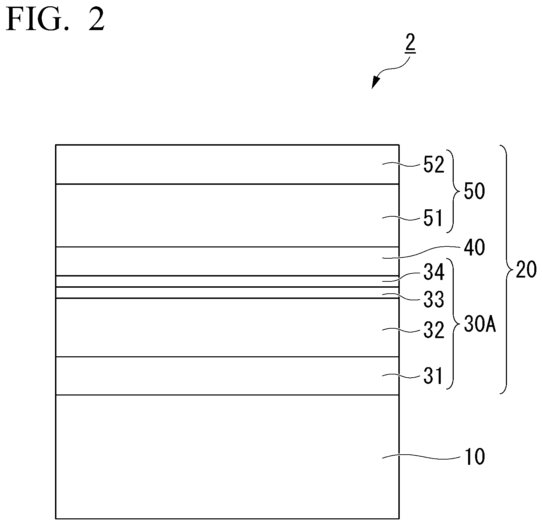

FIG. 2 is a cross-sectional view showing the schematic configuration of a semiconductor optical element according to a second embodiment of the present invention. In FIG. 2, the same reference numerals are given to the configurations corresponding to the configurations shown in FIG. 1.

As shown in FIG. 2, the semiconductor optical element 2 of the present embodiment differs from the semiconductor optical element 1 shown in FIG. 1 in the configuration of the laminate 20. Specifically, the laminate 20 in the present embodiment has a configuration in which the semiconductor layer 30 of the laminate 20 shown in FIG. 1 is replaced with a semiconductor layer 30A.

The semiconductor layer 30A is formed by laminating the cladding layer 31, the first waveguide layer 32, the second waveguide layer 33, and the undoped layer 34 in order from the substrate 10 side. That is, in the semiconductor layer 30A, the undoped layer 34 is provided on a side of the semiconductor layer 30 opposite to the substrate 10 side. The semiconductor optical element 1 shown in FIG. 1 has a configuration in which the second waveguide layer 33 of the laminate 20 is in direct contact with the active layer 40, but the semiconductor optical element 2 of the present embodiment has a configuration in which the undoped layer 34 is disposed between the second waveguide layer 33 and the active layer 40 of the laminate 20.

In the present embodiment, the thicknesses of the second waveguide layer 33 and the undoped layer 34 are not particularly limited, but for example, the sum of the thicknesses of the second waveguide layer 33 and the undoped layer 34 is designed to be the same as the thickness of the second waveguide layer 33 in the first embodiment. From the viewpoint of suppressing the spread of the depletion layer, it is considered that the thickness of the undoped layer 34 is preferably as small as possible.

For example, the thickness of the second waveguide layer 33 may be 25 nm or more, and is more preferably a thickness in a range of 25 to 50 nm and still more preferably a thickness in a range of 45 to 50 nm. When the thickness of the second waveguide layer 33 is 45 nm, the thickness of the undoped layer 34 is, for example, 5 nm. In addition, in the present embodiment, the doping concentration of the second waveguide layer 33 is desirably a concentration in a range of 5 × 10¹⁷ to 1 × 10¹⁸ cm⁻³.

As described above, in the present embodiment, although the undoped layer 34 is disposed between the second waveguide layer 33 and the active layer 40, the spread of the depletion layer can be made smaller than in the related art by the second waveguide layer 33 having a higher doping concentration than the active layer 40 and the first waveguide layer 32. As a result, the operating voltage of the semiconductor optical element 2 can be lowered. In addition, since the thickness of the second waveguide layer 33 is sufficiently smaller than the thickness of the entire waveguide layer including the first waveguide layer 32, the undoped layer 34, the active layer 40, and the waveguide layer 51, the decrease in light emission efficiency due to free carrier absorption does not occur (or is suppressed to a slight decrease).

Although the semiconductor optical element according to the embodiment of the present invention has been described above, the present invention is not limited to the above-described embodiments, and can be freely changed within the scope of the present invention. For example, in the first and second embodiments described above, an example in which the high-concentration doping layer (second waveguide layer 33) is provided near the interface between the semiconductor layers 30 and 30A and the active layer 40 has been described. However, such a high-concentration doping layer may be provided near the interface between the active layer 40 and the semiconductor layer 50, or may be provided near both the interface between the semiconductor layers 30 and 30A and the active layer 40 and the interface between the active layer 40 and the semiconductor layer 50.

However, it is preferable that the high-concentration doping layer is provided near the interface between the semiconductor layers 30 and 30A and the active layer 40 rather than near the interface between the active layer 40 and the semiconductor layer 50. This is because the carrier absorption of the p-type AlGaAs semiconductor layer is about one order of magnitude larger than the carrier absorption of the n-type AlGaAs semiconductor layer, and thus the light emission efficiency significantly decreases even when the thickness of the high-concentration doping layer is small.

In addition, in the above-described embodiments, to facilitate understanding, a case where the first conductivity type is the n-type and the second conductivity type is the p-type has been described as an example. However, the first conductivity type may be the p-type and the second conductivity type may be the n-type. That is, the substrate 10 and the semiconductor layers 30 and 30A may be the p-type, and the semiconductor layer 50 may be the n-type.

### [Specific Configuration Example]

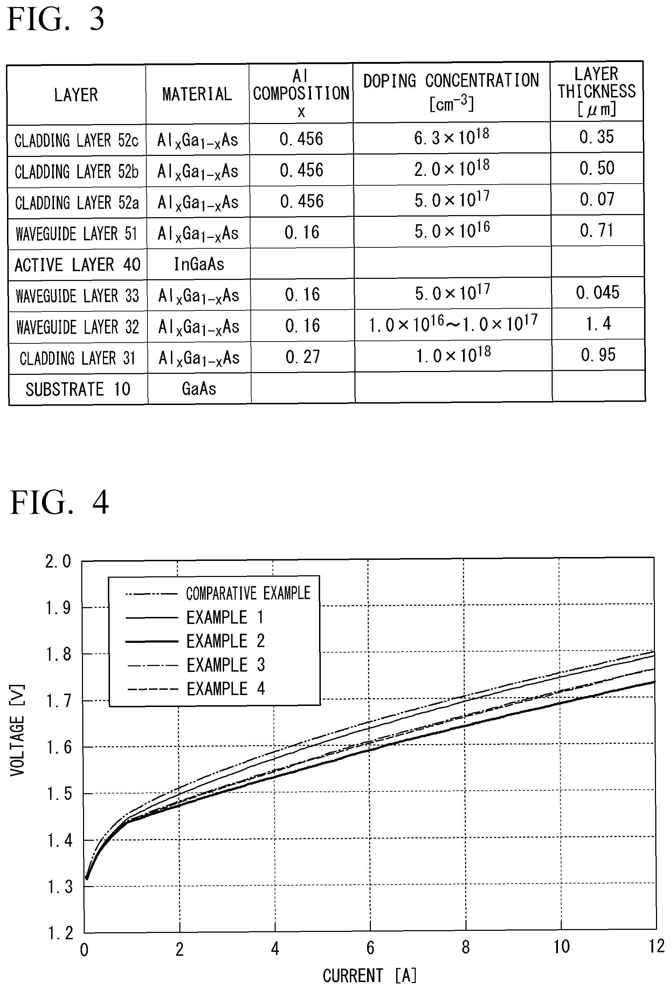

FIG. 3 is a diagram showing an example of a specific configuration of the semiconductor optical element according to the embodiment of the present invention. The configuration example shown in FIG. 3 is an example configuration of the semiconductor optical element 1 according to the first embodiment of the present invention, but the semiconductor optical element 2 according to the second embodiment of the present invention can also have the same configuration as the configuration shown in FIG. 3.

The semiconductor optical element shown in FIG. 3 uses a GaAs-based semiconductor compound. Specifically, the substrate 10 is formed of GaAs, and the active layer 40 is formed of InGaAs. In addition, the semiconductor layer 30 (the cladding layer 31, the first waveguide layer 32, and the second waveguide layer 33) and the semiconductor layer 50 (the waveguide layer 51 and the cladding layer 52) are formed of AlGaAs. In the semiconductor optical element shown in FIG. 3, the cladding layer 52 of the semiconductor layer 50 has a three-layer structure consisting of cladding layers 52a, 52b, and 52c.

The composition x of Al in the cladding layer 31, the first waveguide layer 32, and the second waveguide layer 33 is 0.27, 0.16, and 0.16, respectively. The doping concentrations in the cladding layer 31, the first waveguide layer 32, and the second waveguide layer 33 are 1.0 × 10¹⁸ cm⁻³, 1.0 × 10¹⁶ to 1.0 × 10¹⁷ cm⁻³, and 5.0 × 10¹⁷ cm⁻³, respectively. The thicknesses of the cladding layer 31, the first waveguide layer 32, and the second waveguide layer 33 are 0.95 µm, 1.4 µm, and 0.045 µm, respectively.

The composition x of Al in the waveguide layer 51 is 0.16, and the composition x of Al in all of the cladding layers 52a to 52c is 0.456. The doping concentrations in the waveguide layer 51 and the cladding layers 52a to 52c are 5.0 × 10¹⁶ cm⁻³, 5.0 × 10¹⁷ cm⁻³, 2.0 × 10¹⁸ cm⁻³, and 6.3 × 10¹⁸ cm⁻³, respectively. The thicknesses of the waveguide layer 51 and the cladding layers 52a to 52c are 0.71 µm, 0.07 µm, 0.50 µm, and 0.35 µm, respectively.

FIG. 4 is a diagram showing a change in current-voltage characteristics when the configuration of the n-side layer contiguous to the active layer is changed in the semiconductor optical element having the configuration shown in FIG. 3. In Examples 1 and 2 in FIG. 4, as in the semiconductor optical element 1 shown in FIG. 1, the second waveguide layer 33 is contiguous to the active layer 40. In Examples 3 and 4 in FIG. 4, as in the semiconductor optical element 2 shown in FIG. 2, the undoped layer 34 is provided between the active layer 40 and the second waveguide layer 33, and the undoped layer 34 is contiguous to the active layer 40. In Comparative Example in FIG. 4, as in the semiconductor optical element disclosed in Patent Document 1, the configuration corresponding to the second waveguide layer 33 is not provided, and the undoped layer is contiguous to the active layer 40.

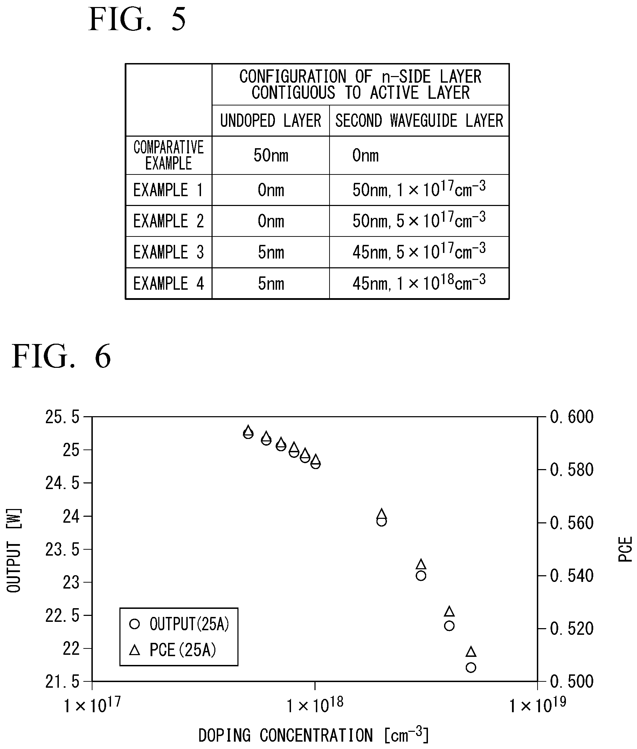

FIG. 5 is a diagram summarizing the configuration of the n-side layer contiguous to the active layer in Examples 1 to 4 and Comparative Example shown in FIG. 4. In Examples 1 and 2, the thicknesses of the second waveguide layer 33 are both 50 nm, but the doping concentrations in the second waveguide layer 33 are different. Specifically, the doping concentration in the second waveguide layer 33 of Example 1 is 1 × 1017 cm-3, and the doping concentration in the second waveguide layer 33 of Example 2 is 5 × 1017 cm-3. In Examples 1 and 2, since the undoped layer is not provided, the thickness of the undoped layer is 0 nm as shown in the drawing.

In Examples 3 and 4, the thickness of the undoped layer 34 is 5 nm, and the thickness of the second waveguide layer 33 is 45 nm, but the doping concentrations in the second waveguide layer 33 are different. Specifically, the doping concentration in the second waveguide layer 33 of Example 3 is 5 × 10¹⁷ cm⁻³, and the doping concentration in the second waveguide layer 33 of Example 4 is 1 × 10¹⁸ cm⁻³.

In Comparative Example, the thickness of the undoped layer is 50 nm. In Comparative Example, since the configuration corresponding to the second waveguide layer 33 is not provided, the thickness of the second waveguide layer 33 is 0 nm as shown in the drawing. As described above, the thickness of the second waveguide layer 33 in Examples 1 and 2, the sum of the thicknesses of the undoped layer 34 and the second waveguide layer 33 in Examples 3 and 4, and the thickness of the undoped layer in Comparative Example are all set to 50 nm.

In FIG. 4, with a focus on Examples 1 and 2 and Comparative Example, the voltage decreases in the order of Comparative Example, Example 1, and Example 2. As a result, it can be seen that, in the configuration of the semiconductor optical element 1 shown in FIG. 1 (the configuration in which the second waveguide layer 33 is contiguous to the active layer 40), the effect of reducing the voltage is obtained when the doping concentration of the second waveguide layer 33 is 1 × 10¹⁷ cm⁻³ or more. In addition, since the voltage is significantly reduced in Example 2 as compared with Example 1, it can be seen that a larger effect of reducing the voltage is obtained by setting the doping concentration of the second waveguide layer 33 to about 5 × 10¹⁷ cm⁻³.

Next, in FIG. 4, with a focus on Examples 3 and 4, the voltage is lower than that in Example 1 and higher than that in Example 2. That is, it can be seen that Examples 3 and 4 achieve an effect of reducing the voltage intermediate between those of Example 1 and Example 2. That is, it can be seen that, in the configuration of the semiconductor optical element 2 shown in FIG. 3 (the configuration in which the undoped layer 34 is provided between the active layer 40 and the second waveguide layer 33), the effect of reducing the voltage is obtained when the doping concentration of the second waveguide layer 33 is a concentration in a range of 5 × 10¹⁷ to 1 × 10¹⁸.

FIG. 6 is a diagram showing changes in output and power conversion efficiency (PCE) when the doping concentration of the second waveguide layer contiguous to the active layer is changed in the semiconductor optical element having the configuration shown in FIG. 3. In FIG. 6, the doping concentration of the second waveguide layer 33 contiguous to the active layer 40 is changed in a range of 5 × 10¹⁷ to 5 × 10¹⁸ cm⁻³. In addition, the driving current of the semiconductor element is set to 25 A.

Here, PCE is a ratio of the light output that can be extracted to the amount of power input to the semiconductor optical element. Specifically, PCE is a value calculated by the equation (light output) ÷ {(driving current) × (driving voltage)}. It can be said that the larger the PCE, the larger the light output with respect to the input power, and the higher the efficiency.

As shown in FIG. 6, it can be seen that the output and PCE of the optical semiconductor element decrease as the doping concentration of the second waveguide layer 33 increases. In addition, it can be seen that, when the doping concentration of the second waveguide layer 33 is 1 × 10¹⁸ or more, the output and PCE of the optical semiconductor element rapidly decrease. Therefore, in the configuration of the semiconductor optical element 1 shown in FIG. 1, it is considered that the upper limit value of the doping concentration of the second waveguide layer 33 is about 1 × 10¹⁸ cm⁻³.

With reference to FIG. 4, in the configuration of the semiconductor optical element 1 shown in FIG. 1 (the configuration in which the second waveguide layer 33 is contiguous to the active layer 40), as described above, it can be seen that the effect of reducing the voltage is obtained when the doping concentration of the second waveguide layer 33 is 1 × 10¹⁷ cm⁻³ or more. Further, with reference to FIG. 6, in addition to FIG. 4, it can be seen that, when the doping concentration of the second waveguide layer 33 is a concentration in a range of 5 × 10¹⁷ to 1 × 10⁸ cm⁻³, a large effect of reducing the voltage is obtained without causing a significant decrease in output and PCE.

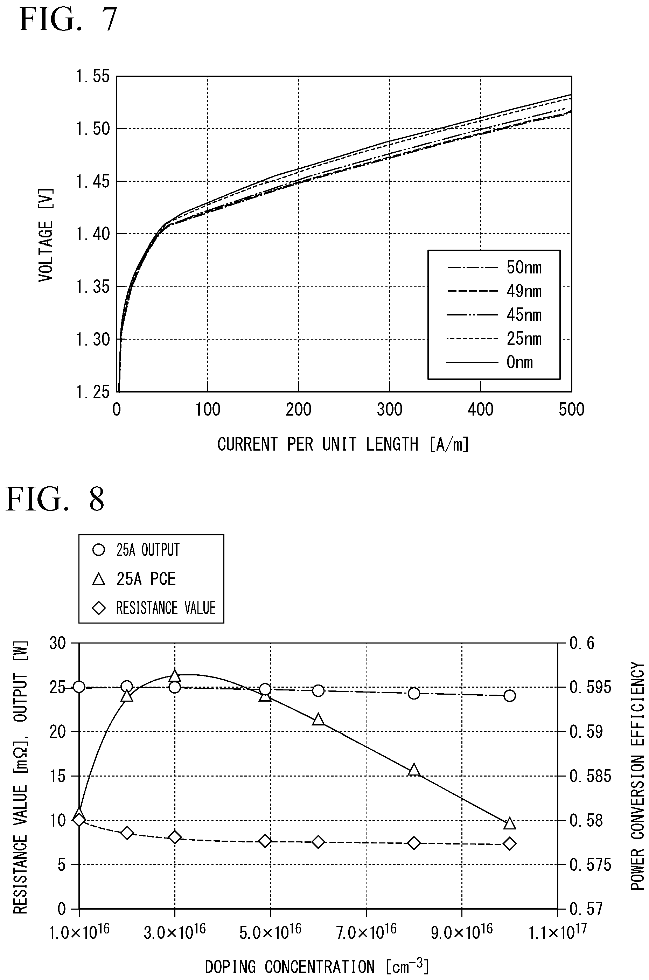

FIG. 7 is a diagram showing a change in the relationship between the current per unit length and the voltage when the thickness of the second waveguide layer contiguous to the active layer is changed in the semiconductor optical element having the configuration shown in FIG. 3. In FIG. 7, the thickness of the second waveguide layer 33 contiguous to the active layer 40 is changed in a range of 0 to 50 nm. As shown in FIG. 7, it can be seen that the voltage decreases as the thickness of the second waveguide layer 33 contiguous to the active layer 40 increases. It can be seen that, in a case where the thickness of the second waveguide layer 33 is in a range of 45 to 50 nm, the voltage is substantially the same. From the above, it can be seen that the effect of reducing the voltage is obtained in a case where the thickness of the second waveguide layer 33 contiguous to the active layer 40 is in a range of 25 to 50 nm, and an even larger effect of reducing the voltage is obtained in a case where the thickness of the second waveguide layer 33 contiguous to the active layer 40 is in a range of 45 to 50 nm.

FIG. 8 is a diagram showing changes in output, power conversion efficiency (PCE), and resistance value when the doping concentration of the first waveguide layer is changed in the semiconductor optical element having the configuration shown in FIG. 3. In FIG. 8, the doping concentration of the first waveguide layer 32 is changed in a range of 1 × 10¹⁶ to 1 × 10¹⁷ cm⁻³. In addition, the driving current of the semiconductor element is set to 25 A.

As shown in FIG. 8, the resistance value and the output of the semiconductor optical element gradually decrease as the doping concentration of the first waveguide layer 32 increases. On the other hand, when the doping concentration of the first waveguide layer 32 is in a range of 1 × 10¹⁶ to 3 × 10¹⁶ cm⁻³, the PCE of the semiconductor optical element increases as the doping concentration increases, but when the doping concentration is higher than 3 × 10¹⁶ cm⁻³, the PCE decreases as the doping concentration increases.

From the results shown in FIG. 8, it can be seen that a high PCE is obtained when the doping concentration of the first waveguide layer 32 is in a range of 2 × 10¹⁶ to 5 × 10¹⁶ cm⁻³. On the other hand, the resistance value of the semiconductor optical element is lower when the doping concentration is in a range of 3 × 10¹⁶ to 5 × 10¹⁶ cm⁻³ than when the doping concentration is 2 × 10¹⁶. From the above, it is desirable that the doping concentration of the first waveguide layer 32 is in a range of 3 × 10¹⁶ to 5 × 10¹⁶ cm⁻³.

The semiconductor optical element according to the present invention is not limited to the above-described embodiments, and is not limited to the above-described specific configuration examples. That is, the present invention can be freely changed within the scope of the present invention. For example, in the above-described embodiments and specific configuration examples, the laminated structure of the semiconductor optical element has been mainly described, but the structures other than the laminated structure are optional. For example, in a case where the semiconductor optical element is an edge-emitting type semiconductor laser, the semiconductor optical element may be a semiconductor laser having a Fabry-Perot resonator structure, or may be a distributed feedback (DFB) semiconductor laser.

In addition, the semiconductor optical element may be provided with a structure for limiting a supply region of a current supplied from an electrode to the active layer 40, as necessary. For example, the supply region of the current supplied from the electrode to the active layer 40 may be limited by forming the electrode provided on the semiconductor layer 50 side in a stripe shape. Alternatively, in the cladding layer 52 of the semiconductor layer 50, the supply region of the current supplied from the electrode to the active layer 40 may be limited by providing a current blocking layer that has an opening for injecting a current and that blocks the current. Alternatively, instead of the current stripe structure, the supply region of the current supplied from the electrode to the active layer 40 may be limited by providing a ridge structure having a current injection region and a current non-injection region.

### REFERENCE SIGNS LIST

1, 2 Semiconductor optical element
10 Substrate
20 Laminate
30 Semiconductor layer
32 First waveguide layer
33 Second waveguide layer
34 Undoped layer
40 Active layer
50 Semiconductor layer

## Claims

1. A semiconductor optical element comprising:
a substrate; and
a laminate in which a first conductivity type semiconductor layer, an active layer, and a second conductivity type semiconductor layer are laminated in order from a substrate side,
wherein at least one of the first conductivity type semiconductor layer and the second conductivity type semiconductor layer has a first waveguide layer and a second waveguide layer, and
the second waveguide layer has a higher doping concentration than the first waveguide layer, and is disposed between the first waveguide layer and the active layer.

2. The semiconductor optical element according to Claim 1,
wherein the doping concentration of the second waveguide layer is two times or more the doping concentration of the first waveguide layer.

3. The semiconductor optical element according to Claim 2,
wherein the doping concentration of the second waveguide layer is 1 × 10¹⁷ cm⁻³ or more and 1 × 10¹⁸ cm⁻³ or less.

4. The semiconductor optical element according to Claim 2,
wherein at least one of the first conductivity type semiconductor layer and the second conductivity type semiconductor layer has, in addition to the first waveguide layer and the second waveguide layer, an undoped layer that is not doped and is disposed between the second waveguide layer and the active layer, and
the doping concentration of the second waveguide layer is 5 × 10¹⁷ cm⁻³ or more and 1 × 10¹⁸ cm⁻³ or less.

5. The semiconductor optical element according to any one of Claims 1 to 4,
wherein a thickness of the second waveguide layer is 25 nm or more and 50 nm or less.

6. The semiconductor optical element according to Claim 5,
wherein the doping concentration of the first waveguide layer is 3 × 10¹⁶ cm⁻³ or more and 5 × 10¹⁶ cm⁻³ or less.
